# EUROPEAN PATENT SPECIFICATION

(11) **EP 2 854 154 B1**
(45) Date of publication and mention of the grant of the patent: **04.07.2018**
(21) Application number: 14184208.8
(22) Date of filing: 10.09.2014
(51) Int. Cl.: H01J 37/317

(54) **Charged-particle multi-beam apparatus having correction plate**
Vorrichtung mit programmierbarer Filterplatte für mehrere geladene Teilchenstrahlen
Appareil à faisceaux multiples de particules chargées doté d'une plaque de filtration

(30) Priority: 11.09.2013 EP 13183963
(43) Date of publication of application: 01.04.2015
(73) Proprietor: IMS Nanofabrication GmbH, 1020 Wien (AT)
(72) Inventor: Platzgummer, Elmar, 1090 Wien (AT)
(74) Representative: Patentanwaltskanzlei Matschnig & Forsthuber OG

(56) References cited:
- JP-A- 2006 019 436
- US-A1- 2013 164 684
- STEFAN EDER KAPL ET AL: "Characterization of CMOS programmable multi-beam blanking arrays as used for programmable multi-beam projection lithography and resistless nanopatterning;Characterization of CMOS programmable multi-beam blanking arrays", JOURNAL OF MICROMECHANICS & MICROENGINEERING, INSTITUTE OF PHYSICS PUBLISHING, BRISTOL, GB, vol. 21, no. 4, 24 March 2011 (2011-03-24) , page 45038, XP020188931, ISSN: 0960-1317, DOI: 10.1088/0960-1317/21/4/045038
- ELMAR PLATZGUMMER ET AL: "eMET: 50 keV electron mask exposure tool development based on proven multi-beam projection technology", PROCEEDINGS OF SPIE, vol. 7823, 24 September 2010 (2010-09-24), page 782308, XP055099481, ISSN: 0277-786X, DOI: 10.1117/12.864261

## Description

### Field of the invention and description of prior art

The invention relates to an advanced programmable multi-beam pattern definition device for use in a charged-particle multi-beam processing (in particular nanopatterning or semiconductor lithography) or inspection apparatus. Furthermore, the invention relates to a charged-particle multi-beam processing or inspection apparatus (such as a nanopatterning or semiconductor lithography apparatus) including this multi-beam pattern definition device.

In particular, said pattern definition device comprises an aperture array field configured to be irradiated with a beam of electrically charged particles and allow passage of the beam through a plurality of apertures thus forming a corresponding number of beamlets, each of the beamlets traversing the aperture array field along a respective beamlet path through the pattern definition device and extending downstream of the pattern definition device to a respective nominal path for each beamlet, wherein the pattern definition device includes a deflection array device positioned across said aperture array field and comprises
- a plurality of blanking openings allowing passage of beamlets through the deflection array device, and
- a plurality of deflection devices, each of said deflection devices being associated with a respective blanking opening and comprising at least one electrostatic electrode, the deflection devices being selectively activatable and configured to influence, when activated, the beamlets traversing said respective blanking openings so as to deflect said beamlets by an amount sufficient to divert said beamlets off their nominal paths.

A pattern definition device (PDD) of the mentioned kind is used to control the exposure of a target (such as a mask blank or wafer substrate) by means of a multitude of charged electron or ion beamlets in order to expose a desired pattern on the target. Within the multi-beam processing/inspection apparatus, the PDD is irradiated with a wide beam of charged-particles and generates a plurality of beamlets, typically several hundreds of thousands, in a two-dimensional array, such as a 512 × 512 array. The plurality of beamlets is then imaged onto the target.

Charged-particle multi-beam lithography and processing is of high interest for nanolithography and nanopatterning applications, such as for multi-beam mask writing and for maskless multi-beam direct write processes on silicon wafer substrates. With regard to the present invention the terms 'target' and 'substrate' are used without difference in meaning.

In particular electron multi-beam writing is a promising concept for the future industrial fabrication of leading-edge photomasks as needed for 193nm immersion lithography, of EUV-masks for extended ultra-violet lithography (EUVL), and of templates (1x masks) for nanoimprint lithography, in particular for sub-20nm semiconductor technology nodes, with extendibility to sub-lOnm technology nodes. For the multi-beam mask writer (MBMW) the applicant has coined the acronym eMET (electron Mask Exposure Tool). Configurations of multi electron beam direct write (EBDW) processing on silicon wafers in multi-column PML2 (short for "Projection Mask-Less Lithography"), configurations are described in US 7,214,951 and US 8,183,543 of the applicant.

A charged-particle multi-beam apparatus with a multi-beam PDD of the above-mentioned kind is disclosed in the US 6,768,125 of the applicant, as relevant prior art. That patent describes a charged-particle lithography and processing method and apparatus dubbed PML2 and further publications of the applicant describe eMET (short for "electron multi-beam Mask Exposure Tool"), both of which realize a multi-beam writing concept and use a PDD for structuring a charged-particle beam, which is extracted from a single source of electrically charged particles (electrons or ions). The PDD is, preferably, a programmable multi-aperture device realized as a so called aperture plate system (APS). The implementation based on a programmable APS allows a significant improvement of the achievable productivity in comparison with focused single spot beam systems as well as variable shaped beam (VSB) systems. The reasons for the improved productivity are, firstly, the parallelism of the process using a plurality of beams and, secondly, the increased current (of all beamlets writing in parallel) which can be imaged to a substrate at the same resolution. As compared with a single electron beam system, the current density at target of the electron multi-beam writing apparatus (in the order of A/cm²) is lower by approx. two orders of magnitude when compared to VSB systems, thus reducing instantaneous heating effects which are unavoidable when using single beam systems with high (> 100A/cm²) current density.

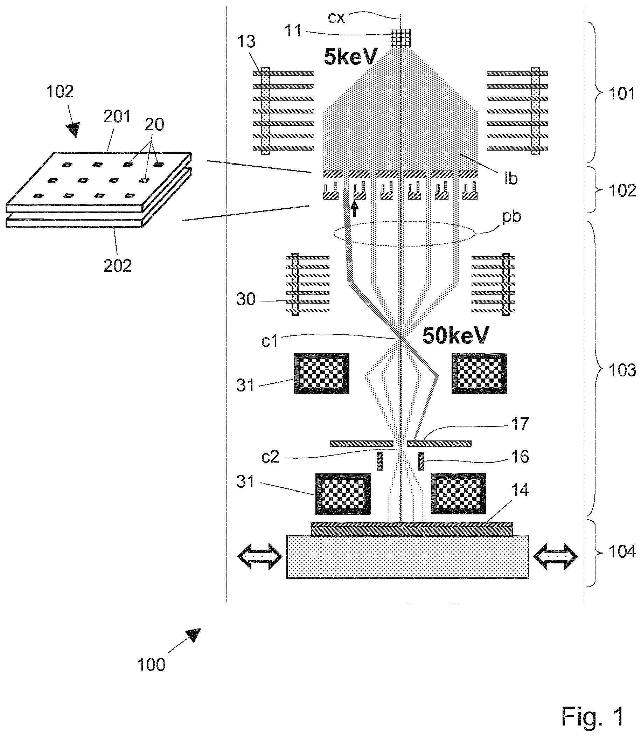

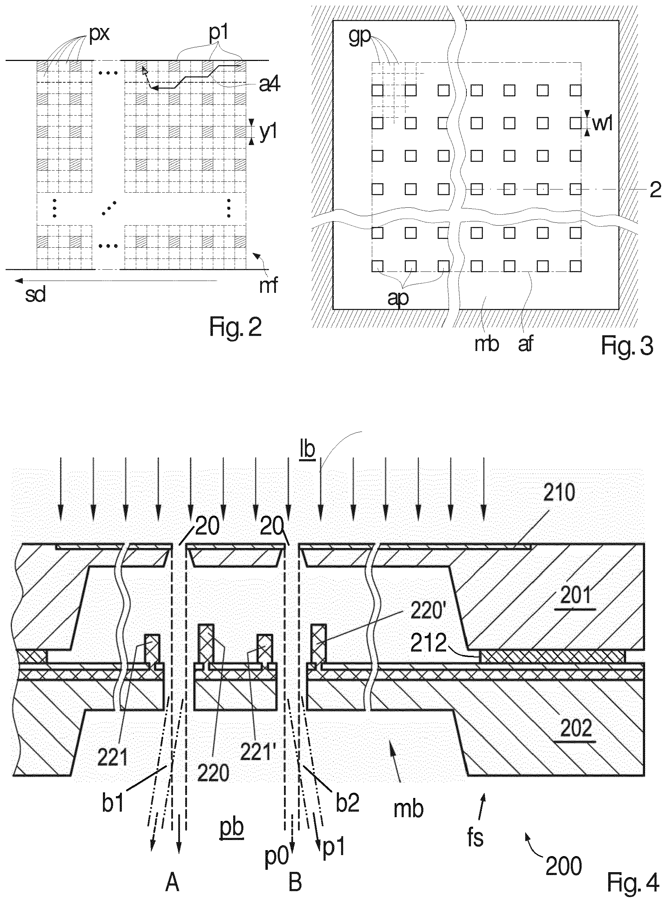

Fig. 1 illustrates an overview of a charged-particle multi-beam apparatus 100 with a PDD 102 underlying the invention. According to APS architecture, the PDD 102 consists of at least two plates 201, 202 in a stacked configuration. The plates have different dedicated functions, namely, an aperture array plate 201 (AAP) and a deflector array plate 202 (DAP). A plurality of beamlets is formed by AAP 201 and pass through larger openings in the DAP 202; in the DAP 202 some of the beamlets are deflected from their nominal paths while the other beamlets pass without being deflected; beamlets deflected in the DAP 202 are filtered out at a stopping plate 17 situated at or near the second cross-over c2 of charged-particle projection optics 103. The beamlets which are not deflected in the DAP 202 continue through the cross-over c2 and are imaged onto a target 14, thus exposing pixels on the target. Fig. 2 illustrates the arrangement mf of pixels p1 which can be exposed by this method on the target 14.

The different kinds of plates in the APS setup of the PDD realize a high integration density of apertures and deflectors. Within the PDD, accurate alignment between the two or more plates and adequate adjustment towards the direction of the incoming beam is required. This alignment can be accomplished in-situ by means of a configuration as disclosed in US 8,546,767.

The DAP has electronic circuitry associated with the apertures to allow "switching on " and "switching off" of the individual beamlets in accordance with the pattern which is to be generated on the target. In particular, the DAP is provided with a deflection array composed of a plurality of deflection devices for deflecting selected beamlets ("switching off"). Each deflection device is located at an opening formed in the DAP and can generate an electrostatic field sufficient to deflect the respective beamlet traversing through the opening from its nominal path. The beamlets which are not deflected are, as already mentioned, imaged onto the target 14.

The DAP is manufactured by three main processing steps: 1) the fabrication of the CMOS circuitry; 2) an etch process for creating the apertures; and 3) a MEMS process for building the capacitive blankers. To date the fabrication process for a DAP is highly reliable, but nonetheless there is always a certain number of the beamlet deflectors in a DAP which are not working in the specified way. The complexity of this manufacturing process may cause a certain failure rate in the functioning of some blankers which can thus not be controlled, resulting in apertures that remain in an open state or apertures that are forever closed. Typically, the number of such beamlet deflector defects is small, below one per mille (i.e., in the order of a hundred for one DAP operated for more than 100-thousand programmable beams). Usually, the beamlet deflector defects are non-clustered, meaning that they are statistically distributed over the field of apertures. Thus, in general one can expect that there are no neighboring beamlet deflector defects, i.e., one can assume that between the locations of two such defects at least one operating beamlet deflector is present, and usually a few.

The beamlet deflector defects result in either "always-off" defects or "always-on" defects. An "always-off" defect is present where the beamlet is either blocked from passage through the PDD or deflected from its path so that it will not reach the target, at all times and in particular regardless of the pattern information. An "always-off" defect may be due to a closed aperture in the aperture array plate and/or DAP, or by the presence of a voltage at the deflection electrodes of the deflector device associated with the respective opening in the DAP, where this voltage cannot be turned off during operation of the DAP. Thus, the beamlet affected by this "always-off" defect is always filtered out and cannot be used to contribute to the exposure of a pattern on the target. Thus, during writing a pattern to a substrate, an "always-off" defect will not allow the passage of the beamlet, which would be needed for a correct exposure.

An "always-on" defect (also called "always-open") occurs where a deflection device is defective, for instance due to a defective electrode or non-operative voltage-supply of the electrode, in such a way that the respective beamlet can always pass through the corresponding aperture, without being deflected at all or without being deflected to an amount sufficient for being completely filtered out before the target (for instance at the stopping plate 17).

It is possible to compensate for the effect of an "always-off" defect within an exposure algorithm which uses redundant writing, such as disclosed in US 8,222,621 of the applicant, by taking into account the location of the beamlet affected by the flawed device and shifting the corresponding amount of exposure to one or more other beamlets within the same redundancy group. The function of the beamlet would thereby be substituted by one or more beamlets at functioning deflection devices. In contrast to such "always-off" defects, an "always-on" defect, besides being a nuisance, is generally more difficult though not impossible to deal with. For an "always-on" defect it is not possible to overcome the effect of unwanted exposure. Thus, it is desired to ensure that a PDD has no "always-on" beam defects.

Therefore, it is an aim of the present invention to provide PDD units without "always-on" beam defects, for instance by suitable ways to correct such PDD units which, upon manufacture thereof, exhibit apertures having this type of defect.

In prior art approaches for compensating a defect beam are described. For instance, JP 2006-019436 A discloses a pattern definition device according to the preamble of claim 1, in particular compensating a beam failure of the "always-off" kind by transferring a neighboring beamlet to the position of the beam failure. In particular, arrays of charged-particle beam deflectors are inserted before or after an aperture array; these multi-deflecting systems enable transferring selected beamlets to the paths of respective neighboring beamlets. This allows to shift a functional beam to the site which the defective beam would have in the aperture array plate.

US 2013/0164684 A1 discloses a "stopping aperture array" and a sealing mechanism device, which supplies a sealing material to selected openings of the "stopping aperture array" so as to block the corresponding beamlets.

### Summary of the invention

This aim is achieved by a PDD as described in claim 1.

In this PDD one or more defective deflection devices are present which are permanently unable to deflect the beamlets traversing blanking openings with which the defective deflection devices are associated, thus leaving such beamlets as "non-deflected beamlets", by means of an additional filtering device. The filtering device is positioned across the aperture array field and comprises
- a plurality of passage openings allowing passage of beamlets through the filtering device for at least the beamlets passing through blanking openings of the deflection array device where the respective deflection devices are not defective, wherein the paths of the respective beamlets are not affected by said filtering device, and
- at least one obstructing device which is programmable to permanently assume an obstructing state where it prevents the non-deflected beamlets from traversing the pattern definition device along their respective nominal paths downstream of the pattern definition device.

In this filtering device, the (at least one) obstructing device is programmable to take two states, namely, an open state not affecting the respective non-deflected beamlet(s) and the obstructing state. In particular, the filtering device is realized as a plate-shaped device ("correction plate") comprising an array of openings which correspond to the plurality of blanking openings of the deflection array device, and a plurality of obstructing devices, each obstructing device being associated with a respective opening and comprising at least one electrostatic electrode. The deflection devices are selectively activatable to realize the obstructing state by diverting the beamlets traversing said respective openings from their nominal path, thus preventing the respective beamlets from traversing the pattern definition device along their respective nominal paths downstream of the pattern definition device for a minimum duration.

This solution provides a device capable of suppressing the unwanted beamlets, which correspond to "always-on" defects, by physical means. In particular, the invention proposes modifying the PDD at the sites where an "always-on" defect is present in such way as to prevent the passage of the respective beamlets towards the target at all times of operation. In other words, all "always-on" defects are converted into "always-off" defects, which are much easier to compensate. It is remarked that the number of defective deflection devices is lower by at least one order of magnitude, but usually two or three orders of magnitude or more, than the complete number of deflection devices in the deflection array device.

The solution according to the invention is fundamentally different from the approach of JP 2006-019436 A since the filtering device of the invention does not include a lens array. All other beamlets are left unaffected so as to propagate along their respective paths, and in particular are not shifted so as to substitute a defective beamlet. The invention provides a way to turn an "always on" defective beam into an "always off" defective beams, in contrast to JP 2006-019436 A where "always off" beams are not tolerated.

Whereas the switching times in the deflection array device need to be very fast in order to achieve productivity of the multi-beam writing or inspection apparatus, the switching times in the programmable obstructing device can be very slow. Thus, the obstructing device is configured to be switchable into the obstructing state for a certain minimum duration. This minimum duration may be greater than the product of the typical duration of activating the deflection devices in the deflection array device times the number of openings in a row of openings in the deflection array device; but often, this minimum duration is even longer and holds for the duration of one or more exposure processes of a target.

In one useful implementation of the PDD the deflection array device is realized as plate-shaped devices comprising a respective array of openings. The filtering device is realized as "correction plate" or "filtering array plate". Furthermore, it is suitable when the filtering device is positioned across the aperture array field substantially parallel to the deflection array device.

In another useful development, the filtering device may also include the function of a (downstream) field-boundary array plate. In this case, the filtering device may be the last component of the pattern definition device as seen along the direction of the beam, and further include a downstream surface of smooth, preferably planar, shape except for said openings, to be oriented towards particle-optical components located downstream of the pattern definition device, such as a projection system for imaging the patterned beam onto the target.

Additionally an aperture array device may be provided comprising the plurality of apertures in the aperture array field; these apertures are configured to define the shape of the beamlets formed in the pattern definition device. The aperture array device is, preferably, positioned separate from the filtering device, i.e., in a small but finite distance.

### Brief description of the drawings

In the following, the present invention is described in more detail with reference to several exemplary embodiments of the invention illustrated in the drawings, which show:
- Fig. 1: an overview of a particle-beam exposure apparatus suitable for the invention in a longitudinal sectional view;
- Fig. 2: illustrates the exposure of pixels accomplished with the apparatus of Fig. 1;
- Fig. 3: shows a bottom plan view of the PDD system in the apparatus of Fig. 1;
- Fig. 4: shows a simplified sectional view of the PDD system in the apparatus of Fig. 1;
- Fig. 5: illustrates a PDD system, shown in a simplified sectional view, having a defective deflection device;
- Fig. 6A: shows a longitudinal sectional view of a particle-beam exposure apparatus including a PDD according to a first embodiment of the invention;
- Fig. 6B: shows an enlarged detail of the PDD of Fig. 6A provided with a programmable correction plate;
- Fig. 6C: shows a variant of the PDD of Fig. 6B with modified sequence of plates;
- Figs. 7A-D: illustrate the electronic layout for programming the correction plate of Fig. 6B;
- Fig. 8: illustrates a background example not forming part of the invention in a longitudinal sectional view, namely, with a passive filtering plate blocking beamlets of the defective deflection device;
- Fig. 9: illustrates another background example not forming part of the invention in a longitudinal sectional view, namely, with a passive filtering plate which also operates as final field-boundary plate; and
- Fig. 10: illustrates still a further background example not forming part of the invention in a longitudinal sectional view, namely, with an aperture array plate (AAP) also serving as passive filtering plate.

### Detailed description of the invention

The various embodiments of the invention discussed in the following are based on a development of the eMET-type charged-particle multi-beam exposure apparatus and its PDD system, having a large-reduction projecting system. In the following, first the technical background of the apparatus is discussed as far as relevant to the invention, then embodiments of the invention are discussed in detail. It should be appreciated that the invention is not restricted to the following embodiments or the particular layout of PDD systems, which merely represent examples of possible implementations of the invention; rather, the invention is suitable for other types of processing systems that employ a charged-particle beam and a multi-beam patterning as well.

### eMET System

A schematic overview of an electron multi-beam mask exposure tool 100 (mask writer) employing the invention is shown in Fig. 1. In the following, only those details are given as needed to disclose the invention; for the sake of clarity, the components are not shown to size in Fig. 1, particularly the lateral width of the particle beam is exaggerated. Similar to eMET are also the principles of the PML2 system; for more details, the reader is referred to the US 6,768,125 and US 7,781,748 with respect to the overall layout of the charged-particle multi-beam apparatus and the PDD system. The eMET system implements a suitable source for generating an electron beam. Equivalent principles apply when using an ion source, instead, for an ion multi-beam tool, which the applicant also has realized (CHARPAN, short for "Charged-Particle Nanopatterning").

The main components of the apparatus 100 are - in the order of the direction of the beam lb, pb which in this example runs vertically downward in Fig. 1 - an illumination system 101, a PDD system 102, a projecting system 103, and a target station 104 with the target or substrate 14. The charged-particle optical systems 101, 103 are realized using either electrostatic lenses only (e.g. when using ion multi-beams) or a combination of electrostatic and magnetic lenses (e.g. when using electron multi-beams). The charged-particle optical parts 101,102,103 of the apparatus 100 are contained in a vacuum housing (not shown) held at high vacuum to ensure an unimpeded propagation of the beam lb, pb along the optical axis of the apparatus.

The illumination system 101 comprises, for instance, an electron or ion source 11, an extractor arrangement defining the location of the virtual source, a general blanker (not shown in Fig.1), which in the case of using ion beams may also be used as ion mass species filter, and an illumination charged-particle optics realized by a charged-particle optical condenser lens system 13. In the embodiment shown the particle source 11 emits energetic electrons of a suitable kinetic energy such as, e.g., 5 keV; in other implementations, other electrically charged particles such as ions of primarily a certain species may be used, such as hydrogen or Ar⁺ ions having a defined (kinetic) energy of typically several keV (e.g. 5 keV at the PDD system 102) with a comparatively small energy spread of, e.g., ΔE = 1 eV. A velocity/energy dependent filter (not shown) may be provided to filter out other, unwanted particle species that may also be produced in the source 11; the filter may also be used to blank out the beam as a whole during repositioning of the beamlets. By means of the condenser lens system 13, the charged particles emitted from the source 11 are formed into a wide-area, substantially telecentric beam serving as beam lb.

The beam lb then irradiates a blanking device which, together with the devices needed to keep its position (not shown), forms the PDD system 102, which is also shown in a schematic perspective detail view at the left-hand side of Fig. 1. The PDD system is held at a specific position in the path of the beam lb, which thus irradiates an aperture array pattern formed by a plurality of apertures 20. As already mentioned, each of the apertures can be "switched on" or "off". In a "switched on" or "open" state, an aperture allows the beamlet passing through the respective aperture to reach the target; it is then said, the aperture is transparent to the incident beam. Otherwise, the aperture is "switched off" or "closed", in which case the beam path of the respective beamlet is affected (e.g. by means of deflection electrodes to which a transverse voltage is applied) in a way that it will be absorbed or otherwise removed out of the beam path before it can reach the target; thus, the aperture is effectively non-transparent or opaque to the beam.

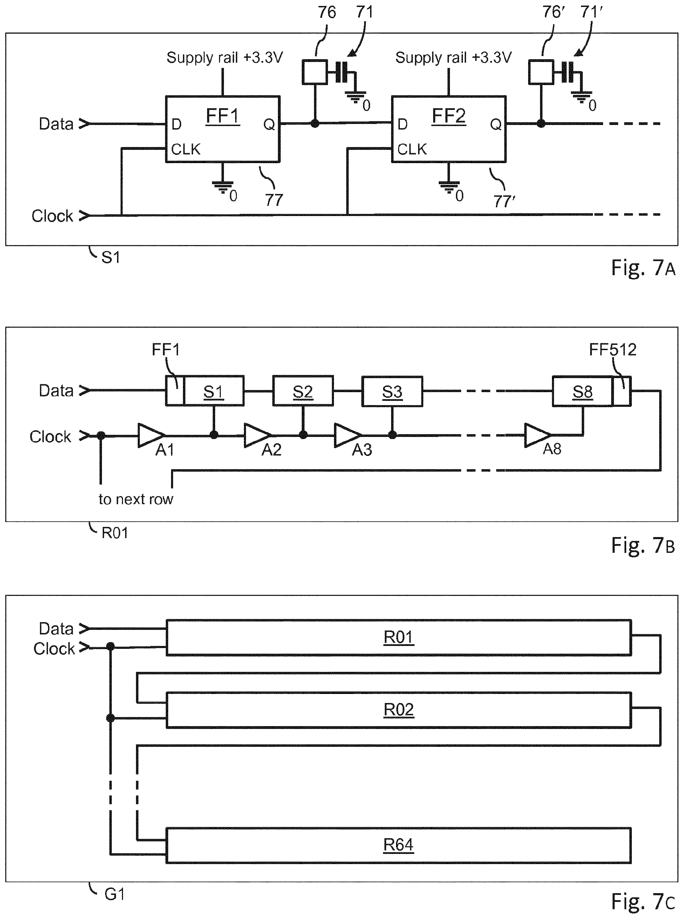

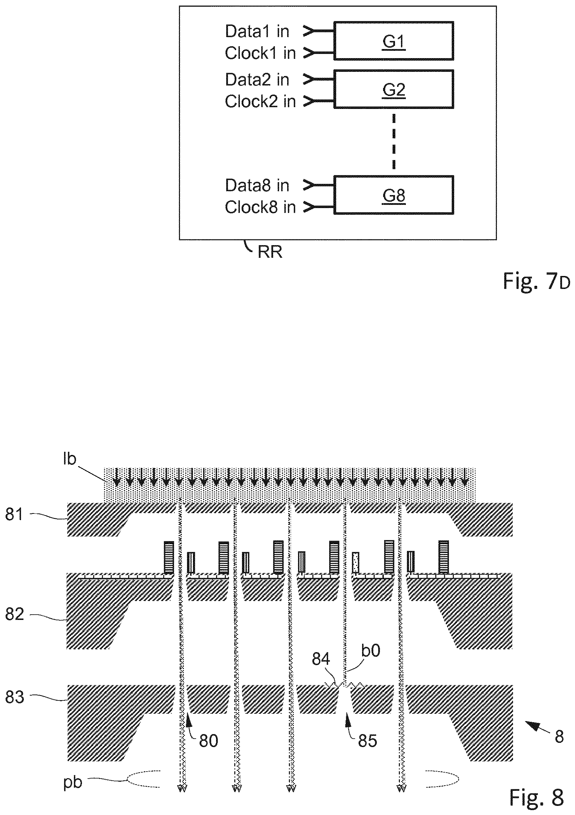

Each switched-off beamlet is absorbed, for instance, on a stopping plate 17, which is situated at or near the second cross-over c2 of the charged particle projection optics; the other beamlets, which are switched-on, pass through a central opening of the plate 17 and thus are projected onto the target. The filtering of deflected beamlets can also (as e.g. shown in Fig.7 of US 6,767,125) take place at a third plate ("terminal plate") placed in the PDD system, further downstream in proximity of the DAP. In contrast, in the layout illustrated in Fig. 1 filtering of deflected beamlets at a stopping plate 17 has the advantages that a terminal plate in the DAP is not needed, and the deflection angle as provided by the DAP to accomplish beam blanking can be significantly smaller.

In Fig. 1 only five beamlets are shown in the patterned beam pb, while it will be clear that the actual number of beamlets is very large, i.e. typically many thousands; of the beamlets shown, the first from the left is depicted switched off (marked by an arrow below the position of the active electrode deflecting this beamlet). The PDD system architecture is discussed in further detail below referring to Figs. 3 and 4.

The switched-on apertures are the only portions of the PDD transparent to the beam lb, which is thus formed into a patterned beam pb emerging from the apertures (i.e., in Fig. 1, below the PDD system 102). By virtue of the pattern defined by the PDD 102, an arbitrary beam pattern can be generated and transferred to the substrate. Depending on the pattern to be exposed on the target there is, from one pixel exposure to the next, a variation of which beamlets are "switched on" or "switched off". Therefore, while the details of the actual pattern are irrelevant for the description of the present invention, it is important to consider that for the proper exposure of a pattern it is required that a considerable number of the beamlets will be switched off in the course of irradiation of the target, with the pattern changing very fast.

A charged-particle optical projection system 103 then projects the pattern as represented by the patterned beam pb towards the substrate 14 (such as a 6" mask blank with resist coating); since the beamlets which are switched off are absorbed at the stopping plate 17, only the switched-on beamlets will form an image of the switched-on apertures. The projection system 103 implements a demagnification of, for instance, 200:1, as realized by the applicant. The substrate 14 may be, for instance, in the case of an eMET-type system a 6-inch mask blank or a nanoimprint 1×mask or master template, covered with an electron sensitive resist layer, whereas for a PML2 system the substrate 14 may be a silicon wafer covered with a charged-particle sensitive resist layer. The substrate 14 is held and positioned by a substrate stage (not shown) of the target station 104.

The projection system 103 is, for instance, composed of two consecutive charged-particle optical projector sections with a crossover c1 and c2, respectively. The charged-particle optical lenses 30, 31 (comprising, for instance, an electrostatic multi-electrode accelerating lens 30 and two magnetic lenses 31) used to realize the projectors are shown in Fig. 1 in symbolic form only as technical realizations of charged-particle imaging systems are well known in the prior art. The first projector section 30 images the plane of the apertures of the PDD system to an intermediate image which in turn is imaged onto the substrate surface by means of the second projector section 31. Both sections employ a demagnifying imaging through crossovers c1,c2; thus, while the intermediate image is inverted, the final image produced on the substrate is upright (non-inverted). The demagnification factor is about 14:1 for either stage, resulting in an overall demagnification of 200:1. A demagnification of this order is in particular suitable with a lithography setup, in order to elevate problems of miniaturization in the PDD system.

As a means to introduce a small lateral shift to the image, i.e. along a direction perpendicular to the optical axis cx, deflection means 16 are provided in one or both of the projector sections. Such deflection means can be realized as, for instance, a multipole electrode system, as discussed in the US 6,768,125. Additionally, an axial current coil may be used to generate a an axial magnetic field providing rotation of the pattern in the substrate plane as needed. The lateral deflections are usually quite small in comparison to the lateral width of the beam array field at the substrate which is the width of the structured beam pb leaving the PDD divided by the reduction factor of the charged-particle projection-optics. Thus, the lateral deflections are at least one order of magnitudes below the width of the beam array field (it should be appreciated in this context that the lateral distance between beamlets is considerably smaller than the mentioned width of the beam array field).

Referring to Fig. 2, the apparatus 100 forms an image field mf on the target 14, which is, for instance, a resist-covered mask blank or wafer. The image field mf has a finite size which is usually well smaller than the total area to be exposed on target. Therefore, a scanning stripe exposure strategy is utilized, where the target is moved under the incident beam, so as to change the position of the beam on the target perpetually: the beam is effectively scanned over the target surface along a scanning direction sd. In the embodiment shown, it is the target which effects the (large-scale) movement, so a beam-scanning strategy is not required for the large-scale movement; it is emphasized that for the purpose of the invention only the relative motion of the image field mf on the target is relevant.

Fig. 2 shows one possible arrangement of a grid of primary pixels p1 within the basic lattice of pattern pixels px. The image field mf is composed of a plurality of pattern pixels px. It should be appreciated, however, that only a subset of the pixels px can be exposed simultaneously (at one time) since only a finite number of apertures is present in the aperture array field of the PD system. The pixels which can be exposed simultaneously are also referred to as primary pixels p1. The primary pixels p1 arranged in a regular rectangular grid; in this case, it is a square-like grid ('quad grid') with a 3 × 3 spacing in the basic lattice. The primary pixels p1 are the images of the apertures 20 in the PDD system, so they reproduce the spatial arrangement of the apertures in the AAP of the PDD system (see Fig. 3), though at a different scale, because of the demagnification of the optical system. In a sequence of consecutive pixel exposure cycles, the image field mf is swept over the target along a path a4 (which is achieved by a movement of the target, a movement of the beam, or a proper combination of both) so as to expose all pixels px on the target in successive way. In addition to the basic relative movement along the sd, a transverse movement is made, for instance by means of the deflection means 16 (Fig.1). After a number of pixels have been exposed in different pixel lines along path a4, the movement shifts back to the original pixel line (plus a linear displacement along the direction sd as effected during the time interval lapsed). Thus, the amplitude of the transverse movement can be small; it will be appreciated that the amplitude is in the order of the mutual distance of beamlets. Other aperture arrangements may implement other geometric figures, such as a staggered grid.

### PDD and DAP

Figs. 3 and 4 illustrate the above-mentioned PDD 200, which is basically in conformance with US 6,768,125 and US 7,276,714 of the applicant, in more detail. Fig. 3 depicts a bottom view of the PDD (view direction against the direction of the illuminating beam) with a regular apertures array, and Fig. 4 shows a longitudinal sectional view according to a section along a plane corresponding to line 4 in Fig. 3. The apertures array may also realize different arrangement, such as a staggered apertures array as shown in US 6,768,125.

The PDD system 200 comprises a number of plates 201, 202 which are mounted in a stacked configuration, realizing a composite device whose components serve respective specific functions. Each of the plates is preferably realized with silicon microsystems technology in which the structures have been formed by micro-structuring techniques as outlined e.g. in US 7,687,783 and US 8,198,601.

A plurality of apertures is located in membranes mb formed by thinned regions of silicon wafers usually cut to a smaller quadratic or rectangular format, forming an aperture array field, designated by reference symbols af in Fig. 3; the membranes mb are stabilized by the surrounding frame fs (Fig. 4, the frame is shown hatched in Fig. 3). Each aperture corresponds to a set of consecutive openings which are defined in said plates. The number of apertures visible in Figs. 3 and 4 is small for the sake of better clarity, to represent a large number of apertures forming the aperture array field in the membranes mb; in Fig. 4, only two apertures are shown. The charged particle beam lb traverses the plates through this array of apertures of the aperture array field af.

The AAP 201 is designed to be irradiated with the broad particle beam and allows passage of charged particles through a plurality of apertures 20 only. Thus, the AAP absorbs the majority of the impingent charged particle beam lb, but the charged particles can pass through a number of apertures 20 of defined shape, thus forming a plurality of beamlets, of which only two beamlets b1, b2 are shown. Each of the beamlets traverses the aperture along a respective beamlet path. Apart from the task of forming the beamlets, the AAP 201 serves to protect the subsequent plate(s) from irradiation damage. In order to avoid local charging the aperture array plate may be coated with an appropriate layer 210, usually a metallic layer forming no oxide (e.g. iridium). When using ion beams, the layer 210 and method of its formation are chosen suitably to prevent the irradiating particles to be incorporated in the silicon crystalline matrix, which would cause a change of membrane stress, as outlined in US 6,858,118.

Referring to Fig. 3, the AAP comprises a plurality of apertures ap arranged within an "orthogonal" aperture array field af along a regular rectangular grid. In the embodiment shown, the aperture array field realizes a regular grid wherein the apertures are spaced in a 3 × 3 grid, for instance, in which the offset between apertures is 3 times the nominal aperture width w1 along either direction of the grid (consequently, the free space between neighboring apertures is 2·w1). This aperture arrangement conforms to the arrangement of primary pixels of Fig. 2. In other words, the aperture array field af realizes a regular array of apertures ap, which are arranged in several rows, each row comprising a number of apertures. For instance, the apertures may be arranged in a 512 × 512 array, i.e., 512 rows of 512 apertures each.

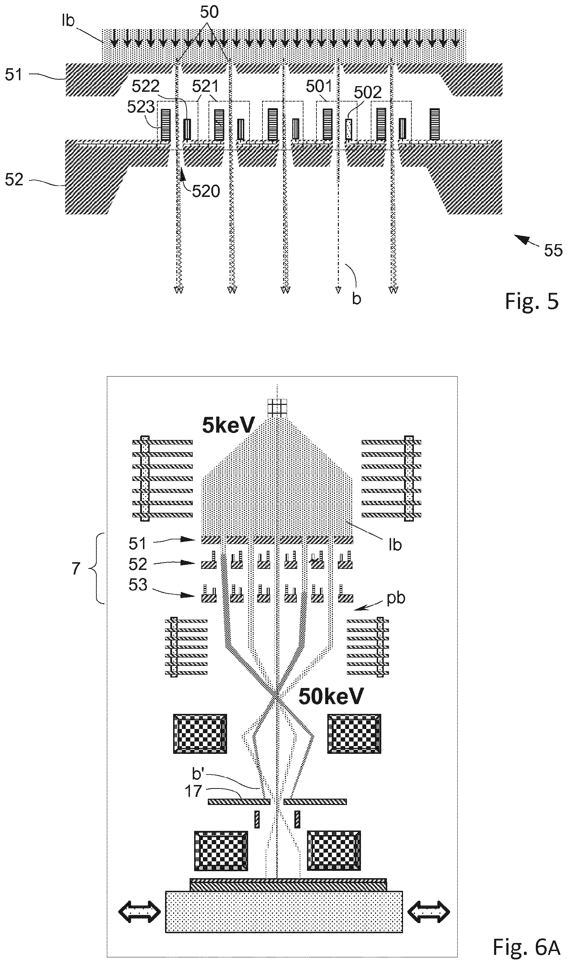

Positioned in proximity to the AAP 201, preferably downstream thereof, a deflector array plate 202 (DAP; also referred to as blanking plate in view of its function in the context of the apparatus 100) is provided. The DAP 202 serves to deflect selected beamlets and thus to alter their beam path. The DAP has a plurality of so called blanking openings, which each correspond to a respective aperture of the aperture array plate 201. As already mentioned and shown in Fig. 4, the blanking openings in the DAP are larger than the openings in the aperture array plate. The area between the DAP openings is used for accommodating CMOS electronics (shown cross-hatched in Figs. 4 and 5) to control and power the beamlet deflection devices. Thus, the beamlets formed with the AAP can pass through the DAP freely (i.e., without geometric obstruction). In the DAP the beamlets can be selectively deflected by an amount sufficient to divert said beamlets off their nominal paths, so that the deflected beamlets cannot reach a target, as described in prior publications of the applicant.

Each blanking opening in the DAP is provided with a beamlet deflection device which allows to individually deflect charged particles transgressing through the opening, thus diverting the beamlet traversing the opening off its path. Each beamlet deflection device includes a set of beamlet deflection electrodes, usually a pair. Preferably, each set has electrodes of different types: a first type are 'ground electrodes', which are applied at the potential of the PD device, whereas another type, which is called here the 'active electrodes', are applied individual potentials in order to deflect the beamlet transgressing the corresponding blanking opening. The ground electrodes may be shared between adjacent beamlet deflection devices. They may be formed so as to have a substantial height over the height of the active electrodes. This is done in order to provide sufficient shielding of the blanking deflection device against cross-talking and other unwanted effects such as lens effects incurred by the deflection electrode geometry.

In the DAP illustrated in Fig. 4, each beamlet deflection device comprises an active electrode 221, 221' and a ground electrode 220, 220' respectively. The electrodes are for instance freestanding with respect to the DAP base membrane. Such electrodes may be formed by perpendicular growth employing state of the art techniques as for instance electroplating techniques.

For instance, beamlet b1 transgresses the subsequent larger opening of the pattern definition system 102 without being deflected, since the beamlet deflection device formed by the respective set of beamlet deflection electrodes is not energized, meaning here that no voltage is applied between the active electrode 221 and the associated ground electrode 220. This corresponds to the "switched-on" state of the aperture. Beamlet b1 passes the pattern definition system 102 unaffected and is focused by the particle-optical system through the crossovers and imaged onto the target with a reduction as induced by the charged-particle projection optics. For example, in systems implemented by the applicant, a reduction factor as large as 200:1 was realized. In contrast, as shown with beamlet b2, a "switched-off" state is realized by energizing the beamlet deflection device of this aperture, i.e. applying a voltage to the active electrode 221' with regard to the corresponding ground electrode. In this state, the beamlet deflection device formed by electrodes 220',221' generates a local electric field across the path of the corresponding beamlet b2 and thus deflects the beamlet b2 off its normal path p0 to a deflected direction. As a consequence the beamlet will, on its way through the charged-particle optical system, obey an altered path p1 and be absorbed at an absorbing means provided in the PDD system or the charged-particle optical system (e.g. at the stopping plate 17, Fig. 1), rather than reaching the target. Thus, beamlet b2 is blanked. The beam deflection angle is largely exaggerated in Fig. 4; it is, in general, very small, typically 0.2 to 1 thousands of a radian.

In the configuration shown in Fig. 4, the plates 201, 202 are bonded together at bonding regions 212 in the frame fs by means of known bonding techniques. In other variants, the plates may be mechanically separate and held in their position by adjustable holding apparatus as described for instance in US 2011/0204253 A1 of the applicant. This has the advantage that the aperture array plate is not influenced by positional changes of the DAP. Slight positional changes of the DAP with regard to the other plates may be tolerated as the DAP has only the purpose to deflect individual beamlets whereas not deflected beamlets are passing through the DAP and are imaged to the substrate.

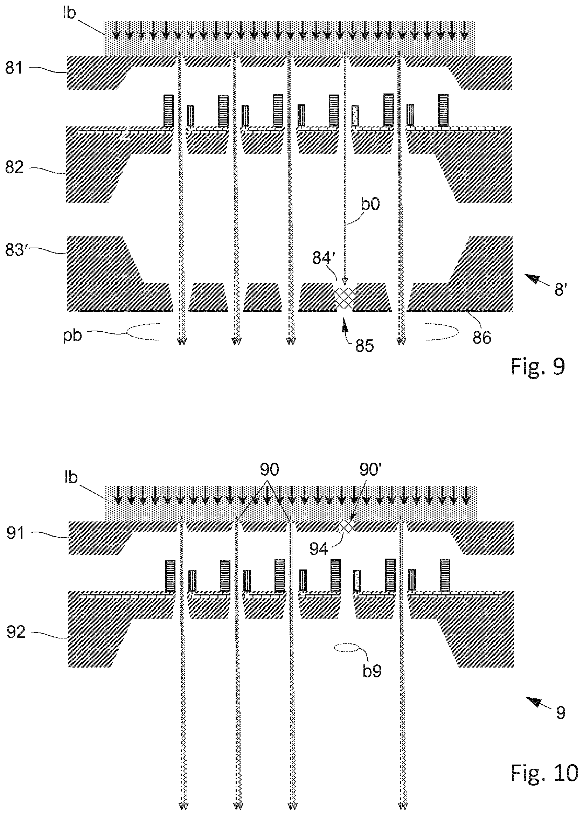

It is to be noted out that the PDD system may further include an additional plate (not shown, but see the variant of Fig. 9), a so called Field-boundary Array Plate (FAP), which provides a defined interface between the PDD 102 and the charged-particle projection optics 103 in terms of the electric field.

### Deflection Defects

Fig. 5 shows, in a sectional view similar to Fig. 4, a simplified example of an PDD system 55 having a defective beamlet deflector producing an "always-on" defect. Realistically, in view of the large number of may thousands of beamlets and deflection devices in a typical PDD system, one has to take into account that some, albeit only very few, of the deflection devices may be defective. The PDD 55 comprises an aperture array plate 51 and a DAP 52. Five beamlets, which are defined in the apertures 50 of the aperture array plate 51, are shown, representing a much larger number of beamlets present in a realistic PDD setup. Each of the beamlets traverses the DAP 52 through a respective opening 520, and at the location of each opening 520, a deflection device 521 is provided. Each of the deflection devices 521 comprises at least two electrodes, for instance at least one active electrode 522 operates against a counter electrode 523. The counter electrodes of the deflection devices are held at a common "ground potential"; they may be separate or connected with each other.

Furthermore, in Fig. 5 one of the deflection devices 521 is defective, namely, the device 501 associated with beamlet b. This device 501 forms a defective deflection device (DDD) having an "always-on" defect, for instance due to a broken voltage supply of the active electrode 502. Thus, the beamlet b will always be in a switched-on state propagating along its nominal path, since regardless of the pattern information supplied to the deflection control unit of this DDD no deflection effect is accomplished, whereas the other beamlets (which are associated with functioning deflection devices 521) can be switched between a switched-on and a switched-off state, as illustrated by doubled arrows at the bottom of Fig. 5.

Such "always-on" defects can be detected by using in-situ beam diagnostics, or it might also be that the position of such beam defect is known from the characterization of the PDD unit prior to inserting it into the multi-beam writing or inspection tool. In particular, each DAP can be tested with a dedicated test bench in order to find openings having a deflector defect. A test bench suitable for this purpose is described in the article of S. Eder-Kapl et al. "Characterization of CMOS programmable multi-beam blanking arrays as used for programmable multi-beam projections lithography and resistless nanopatterning", J. Micromech. Microeng. 21 (2011) 045038 (doi:10.1088/0960-1317/21/4/045038). This test provides a map of the locations of "always-on" and "always-off" defects. Thus, it is possible to determine the number and positions of DDDs for each DAP.

### Programmable Correction Plate

A first approach to correct "always-on" defects according to the invention is by using a correction plate, which is used as an in-situ device for eliminating "always-on" defects. In one preferable realization this correction plate is an additional plate-shaped device which is inserted to the plate stack of the PD device.

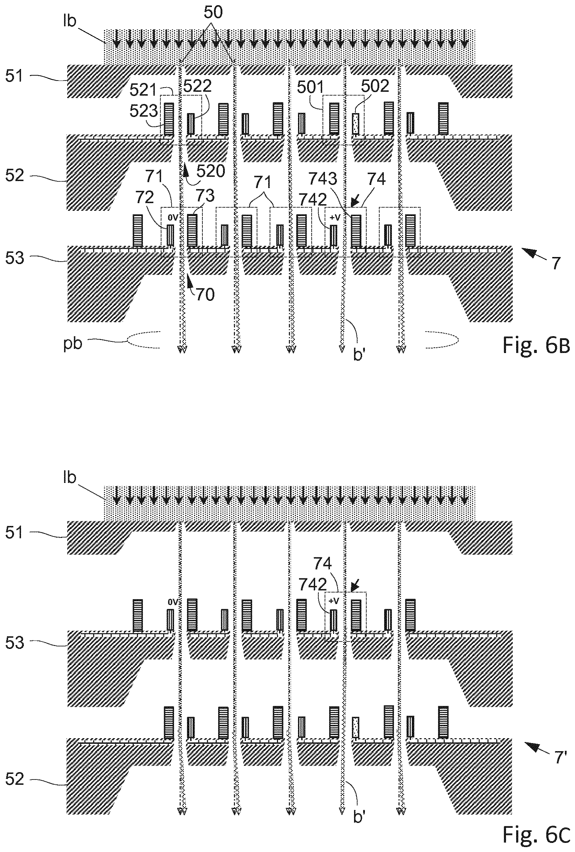

Fig. 6A shows a multi-beam apparatus with a PDD system 7 according to a first embodiment of the invention. Fig. 6B shows the PDD 7 in an enlarged detail. Besides aperture array plate 51 and DAP 52, which correspond to those of Fig. 5, the PDD 7 includes an additional plate-shaped device 53, referred to as correction plate, representing one embodiment of a filtering device according to the invention. The correction plate 53 is configured to always act on selected beamlets, i.e. to deflect such (always-on) beamlets in a way that they are then filtered out in the projection optics, for instance at a stopping plate 17 or other absorbing surface, as shown in Fig. 6A for beamlet b'; the other beamlets are not affected by the correction plate 53. Fig. 6A shows one specific switching state for the beamlets, in which the leftmost beamlet (which is controlled by an operating deflection devices) and the beamlet b' are deflected ("switched-off") while the other beamlets are switched-on and reach the target.

The correction plate 53 is a programmable device superficially similar to the DAP, having the ability to deflect or let pass the individual beamlets emanated by the DAP. In contrast to the DAP, the configuration of deflection will be kept during the entire processing of an exposure. The correction plate 53 is positioned within the PDD system, for instance at a short distance downstream the DAP 52. The correction plate 53 is usually configured with the same number and geometric positions of openings 70 as the DAP 52 with its openings 520.

In particular, the correction plate 53 is provided with a plurality of correction deflection device 71 (CDD), each of which is located at the site of one respective opening 70, such as to be able to deflect the beamlet traversing that opening 70 when activated. For instance, each of the CDDs 71 comprises at least two electrodes, for instance at least one active electrode 72 operating against a counter electrode 73. The counter electrodes 73 of the CDDs may be separate or connected with each other; they may be held at a common "ground potential", or they may be applied a counter potential, for instance of same value but opposite sign as the potential of the active electrode 72, when the CDD is activated.

In Fig. 6B the correction of a DDD 501 in the DAP 52 is shown for the example of beamlet b' corresponding to the CDD 74. The CDD 74 is activated, for instance, by applying an electrostatic potential to the active electrode 742 which generates an electrostatic field in cooperation with the corresponding counter electrode 743. Thus, the beamlet b' will always be deflected off its nominal path, while the other beamlets (which are associated with functioning deflection devices 521) can be switched between a switched-on and a switched-off state as before, as illustrated by doubled arrows at the bottom of Fig. 5B.

In the embodiment shown in Fig. 6B the correction plate is located downstream of the DAP. However, as illustrated in Fig. 6c, positioning the correction plate 53 upstream of the DAP 52 is equally well possible in a PDD system 7', since the deflection angle involved is very small, so it is unproblematic that a beamlet deflected by the correction plate will also pass through the opening of the DAP.

It is important to note that there are decisive differences between a DAP 52 and a correction plate 53 of the invention: While the DAP 52 has to include a fast CMOS circuitry in order to account for the fast-changing pattern information, the circuitry of the correction plate 53 can be slow since the mode of operation in the correction plate will stay constant over at least the duration of an entire exposure treatment of the target 14. It is sufficient that the circuitry of the correction plate 53 can be held in a programmed state for a minimum duration which corresponds to the duration of the exposure of a wafer, which is a multiple (by orders of magnitude) of the duration of the exposure of a row of pixels on the target. In terms of the elements in the PDD, this duration is a multiple of product of the duration of activating a deflection device 521 in the DAP 52 times the number of apertures in a row of apertures in the aperture field af. For instance, an implementation of the correction plate circuitry may include simply wired components or may be realized as simple (flip-flop) slow CMOS circuitry. The latter is discussed more in detail in the following, referring to Figs. 7A-D.

### Design of Logic Circuit of the Programmable Correction Plate

Referring to Figs. 7A to 7D an implementation of a flip-flop circuitry RR (Fig. 7D) of a correction plate 53 includes a plurality of shift registers arranged in rows. Each shift register has a logic output connected to the electrode supply unit of the respective CDD; this supply unit is referred to as "blanker". Before an exposure takes place, these rows of shift registers will be loaded with a pattern defining which beamlets are to be deflected permanently, where the logic state of each bit of the pattern determines the associated blanker state. The pattern will be held in the shift registers and is kept unaltered during exposure. The example shown here relates to a correction plate for an array of 2¹⁸ = 262144 beamlets, which traverse a corresponding number of openings arranged in a 512 by 512 matrix, like the one of Fig. 3 which shows only a small fraction of the openings.

Fig. 7a shows two registers 77, 77' for programming respective blankers 76, representing the first two of 64 registers forming a queue sequence S1. A sequence of 8 queues S1, S2, ... S8 connected serially forms a row R01 comprising 512 flip flop registers FF1 to FF512, as visible in Fig. 7B. As depicted in Fig. 7c, 64 of these register rows R01, R02, ... R64 are connected in a serial sequence to form a group G1 (= 32768 flip flops). Fig. 7D shows that 8 groups G1, G2, ... G8 are combined so as to form a shift register array RR comprising a total of 262144 registers.

Prior to operating the PD device, a bit pattern is loaded into the shift register array RR of the correction plate and will then remain there either statically or until a new pattern is loaded (or power is lost). Each bit in one of the shift registers 77 has two states (low and high). The low state of the register sets the blanker 76 of the respective deflection device to "open", by not applying a voltage and thus allowing the beamlet to pass undeflected, whereas the high state causes the blanker 76 to apply a voltage to the electrodes, so as to effect deflecting the respective beamlet. The bit pattern loaded into the array is by default made up of low bits, allowing all beamlets to pass. Only those bits that correspond to defective, permanently open deflection devices in the DAP, are set high.

Fig. 7A shows two instances of the electrostatic circuitry for programming the CDDs of the correcting plate 53. Each opening (not shown in Fig. 7) is associated with a corresponding CDD 71 and blanker 76. For each blanker 76 a single shift register 77 is provided; this shift register 77 is a D-type flip flop with one data input, one data output and one clock input, marked D, CLK, and Q, respectively. The logic circuit has a 3.3 V supply, which may also be used to supply the blankers; the voltage supply for the electrodes of the CDD 71 is not shown. 64 flip flop registers are connected this way into a queue sequence S1. In the queue sequence S1, each data output Q of a register 77 is connected directly to the corresponding blanker 76 and to the data input D of the next flip flop; the output of the last flip flop leaves the queue S1 for feeding a successive queue sequence S2 (Fig. 7B).

As illustrated in Fig. 7D the plurality of 2¹⁸ registers, which are present in the plate 53 of this example, is subdivided into 8 groups, each group comprising 32768 registers. Each group G1 ... G8 has, as its input, one data input line and clock input line, numbered Datalin, Clocklin for group G1 to Data8in, Clock8in for group G8; the inputs Datalin, Clocklin of the first group G1 corresponds to the input lines Data, Clock of Figs. 7A to 7c. The number of registers in a group exceeds the number of openings in a row on the correction plate, which is 512. As illustrated in Fig. 7c for group G1, each group is geometrically arranged in 64 rows R01, R02, ... R64. Thus, the clock input line Clocklin is used to drive the registers of 32768 registers (64 rows of 512 flip flops). Since this number exceeds the fanout of the external device providing the clock signal by far, each row R01...R64 comprises a number of repeaters A1, A2, ... A8, which is shown in Fig. 7B for row R01. Thus, in each row, eight repeaters A1...A8 are provided, one for each of queue sequences S1...S8 of 64 flip flops each.

Under vacuum conditions, the temperature of the correction plate 53 will be controlled by radiative cooling only. In order to minimize the current being drawn from the power source and to reduce heat production from switching processes during loading of the pattern, the eight groups G1...G8 will be loaded with the pattern data in succession, one at a time, by means of separate data Data1in...Data8in and clock signals Clock1in...Clock8in. The clock cycle time is chosen suitably so that the propagation delay of the cascaded clock repeaters is accounted for, since the clock signal arriving at the last flip flop takes 8 propagation delays of repeaters A1 to A8 .

The row-style layout of the circuit array RR shown in Figs. 7A-7D allows a simple implementation in a wafer die based device since it is based on a single row of 512 flip flop registers, which is repeated on the die multiple times, with only one line running from the end of a row to the beginning of the next row.

### Passive Filtering Array Plate

In another approach, not forming part of the invention and analogous to the approach taken in US 2013/164684 A, a filtering device is realized as a passive plate in the APS, where "passive" denotes that the plate does not have a circuitry to deflect beamlets. In the passive filtering plate an array of openings/ apertures is provided, but it is modified such that openings are missing, or have been closed, at those sites which correspond to the locations of the "always-on" defects.

To obtain such a modified array, for instance, one possibility is to use a repair system based, e.g., on a focused ion beam (FIB) system, in which a gas injection supported deposition is used to close the openings at the sites of an "always-on" defect. This approach uses the fact that with FIB-induced deposition there is not only a deposition onto the surface, but always a side growth as well. This can be exploited to bridge openings, thus covering them, starting the FIB-induced deposition at one or more edges of the opening and then moving on the beam across the area of the opening, until the complete area of the opening is covered by deposited material. Instead of FIB-induced deposition, laser-beam or electron-beam induced deposition methods may be used as well.

Thus, referring to Fig. 8, the PDD system 8 is provided with a passive "filtering array plate" 83. The filtering array plate 83 is produced starting from a membrane plate having an arrangement of openings 80 like those in the DAP 82 but without the circuitry layer. Filling selected openings 85, namely those which correspond to openings with DDDs in the DAP 82, with suitable material will create "nontransparent sites" 84. During this process care must be taken that all other openings 80 are kept open. The filling material may be applied to the upper surface of the opening and/or its lower surface, and/or within the opening. Preferably, the width of the openings 80 in the plate 83 is larger than the width of openings in the DAP, in order to ensure unimpeded propagation of the respective beamlets through the openings 85 that are kept open.

The filtering array plate 83 is then combined with the (partially defective) DAP 82 while the original aperture array plate 81 is kept. The material in the site 84 will absorb or otherwise obstruct the passage of the respective beamlet b0 and thus prevents its passage through the PDD system 8. Thus, a PDD 8 is produced which avoids the "always-on" defects for the beamlets, and the obstruction site 84 serves as obstructing device.

In an analogous manner as with Figs. 6B and 6C, the filtering array plate 83 may be located downstream or upstream of the DAP 82.

Fig. 9 illustrates a variant of Fig. 8, wherein the PDD system includes a (downstream) field-boundary array plate (FAP) as final plate, which may suitably realized by the filtering array plate, merging both functions in one component. In the PDD system 8', the filtering array plate 83' is oriented such that it exhibits a smooth, preferably planar, downstream surface 86, except for the openings through which the beamlets traverse. To realize this surface 86, the orientation of the plate 83' is suitably inverted ("flipped over") as compared to the analogous plate 83 of Fig. 8. In order to ensure a good definition of an equipotential plane, the surface 86 may include an electrically conducting layer. The surface 86, by virtue of its downstream orientation, i.e. towards the charged-particle projection optics 103, provides a defined interface between the PDD 102 and the projection optics 103 in terms of the electric field. In its function as a filtering array plate, the plate 83' comprises an array of openings 80 wherein selected openings 85 which correspond to openings with DDDs in the DAP 82, are filled with suitable material so as to generate nontransparent sites 84'. The location of the material in the opening 85' may be chosen as suitable; preferably, the material is applied so as to form a flush surface with the downstream surface 86 of the plate 83'.

It is to be noted that in all embodiments and background examples, the first plate of the PDD system can also serve as upstream FAP, by virtue of its planar surface which is oriented towards the illumination system 101. In order to enhance this function it may suitably include an electrically conducting cover layer (not shown).

It is further to be noted that also a programmable correction plate (cf. Figs. 6B and 6C) may be adapted so as to serve as a downstream or upstream FAP. In this case, the CDDs will be located at the inner surface of the programmable correction plate (rather than on the opposite to the layout shown in Figs. 6B and 6c), so the opposite surface represents a uniform, suitably planar, surface (possibly including an electrically conducting cover layer) disregarding the opening for the beamlets. The plate is oriented such that the uniform/planar surface is oriented facing outwards, i.e. upstream towards the irradiating beam lb in the case of an upstream FAP, or downstream in the case of a downstream FAP.

In another variant not forming part of the claimed invention, shown in Fig. 10, the AAP may be modified so as to operate as filtering device. This variant starts from the AAP, or a copy of it, which has the full array of openings (see AAP 81 of Fig. 8), and a "filtering aperture array plate" 91 is produced by filling openings 90' corresponding to DDDs with material to create a "nontransparent site" 94 which absorbs or otherwise obstructs the passage of particles of the irradiating beam lb. During this process care must be taken that all other openings 90 are kept open. The absorbing material 94 thus forms an obstructing device which inhibits passage of a beamlet through the PDD system at the relevant location, by suppressing the formation of a beamlet b9 in the first place. This filtering aperture array plate 91 is then combined with the DAP 92, replacing the original AAP. In a further alternative not forming part of the claimed invention, a filtering aperture array plate may be produced having an aperture array with pre-defined missing apertures at the sites of "always-on" defects, by means of a fabrication process of state of the art where the plate pattern is written with an electron beam. This kind of fabrication process is straightforward. Therefore, this alternative of producing a modified aperture array plate is expected to be very effective as well.

## Claims

1. A pattern definition device (7, 7') for use in a charged-particle multi-beam processing or inspection apparatus (100), said device comprising an aperture array field (af) configured to be irradiated with a beam (lp) of electrically charged particles and allow passage of the beam through a plurality of apertures thus forming a corresponding number of beamlets, each of the beamlets traversing the aperture array field (af) along a respective beamlet path (p0) through the pattern definition device and extending downstream of the pattern definition device to a respective nominal path for each beamlet,
the pattern definition device (7, 7') including an aperture array device (51) positioned across the aperture array field (af) and a deflection array device (52) positioned across the aperture array field (af),
said aperture array device (51) comprising said plurality of apertures (50) in the aperture array field, which apertures (50) are configured to define the shape of the beamlets formed in the pattern definition device,
said deflection array device (52) comprising
- a plurality of blanking openings (520) allowing passage of beamlets through the deflection array device, and
- a plurality of deflection devices (521, 501), each of said deflection devices being associated with a respective blanking opening (520) and comprising at least one electrostatic electrode (522, 523, 502), the deflection devices being selectively activatable and configured to influence, when activated, the beamlets traversing said respective blanking openings so as to deflect said beamlets by an amount sufficient to divert said beamlets off their nominal paths, except for one or more defective deflection devices (501) which are permanently unable to deflect the beamlets traversing blanking openings with which the defective deflection devices are associated, thus leaving such beamlets (b') as "non-deflected beamlets", the pattern definition device (7,7') further comprising a filtering device (53) realized as a plate-shaped device comprising
- a plurality of passage openings (70) realized as an array of openings which correspond to the plurality of blanking openings (520) of the deflection array device (52) and which allow passage of beamlets through the filtering device for at least the beamlets passing through blanking openings (520) of the deflection array device (52) where the respective deflection devices (521) are not defective, and
- a plurality of obstructing devices (71, 74), each obstructing device being associated with a respective opening (70) and comprising at least one electrostatic electrode (72, 73, 742, 743), wherein each obstructing device is programmable to take two permanent states with respect to at least one of the non-deflected beamlets (b'), namely, an open state (71) not affecting the respective non-deflected beamlet(s) and an obstructing state (74), wherein the obstructing devices are selectively activatable to realize the obstructing state (74) by diverting the beamlets traversing said respective openings from their nominal path, thus preventing the respective beamlets from traversing the pattern definition device (7, 7') along their respective nominal paths downstream of the pattern definition device for a minimum duration,
**characterised in that** the paths of all those beamlets, which pass through blanking openings (520) of the deflection array device (52) where the respective deflection devices (521) are not defective, are not affected by said filtering device (53).

2. The pattern definition device of claim 1, wherein the openings in the aperture array field (af) are arranged in an array comprising multiple rows of openings, each row comprising a number of openings.

3. The pattern definition device of claim 1, wherein the obstructing device (71) is configured to be switchable into the obstructing state (74) for a minimum duration greater than the product of the typical duration of activating the deflection devices (521) in the deflection array device (52) times the number of openings in a row of openings in the deflection array device.

4. The pattern definition device of any one of the preceding claims, wherein the deflection array device (52) is realized as a plate shaped device comprising a respective array of openings (70), and the filtering device (53) is positioned across the aperture array field substantially parallel to the deflection array device (52).

5. The pattern definition device of any one of the preceding claims, wherein the aperture array device (51) and the deflection array device (52) are realized as different components in a stacked configuration.

6. The pattern definition device of any one of the preceding claims, wherein the filtering device (53) represents the last component of the pattern definition device as seen along the direction of the beam and includes a downstream surface of smooth, preferably planar, shape except for said openings.

7. The pattern definition device of any one of the preceding claims, wherein the number of defective deflection devices is at least one order of magnitude lower than the complete number of deflection devices in the deflection array device.

8. Particle-beam processing or inspection apparatus (100) comprising a multi-beam pattern definition device (7, 7') according to any one of the preceding claims.

## Patentansprüche

1. Musterdefinitionsvorrichtung (7, 7') zur Verwendung in einem Geladene-Teilchen-Multistrahl-Bearbeitungs- oder -Inspektionsgerät (100), mit einer Aperturenarray-Anordnung (af), die dazu eingerichtet ist, mit einem Strahl (lp) elektrisch geladener Teilchen beleuchtet zu werden und den Durchtritt des Strahls durch eine Vielzahl von Aperturen zu ermöglichen, wodurch eine entsprechende Anzahl von Teilstrahlen gebildet wird, wobei jeder der Teilstrahlen die Aperturenarray-Anordnung (af) entlang einer jeweiligen Teilstrahlbahn (p0) durch die Musterdefinitionsvorrichtung durchquert und sich stromabwärts der Musterdefinitionsvorrichtung in eine nominelle Bahn für jeden Teilstrahl erstreckt,
wobei die Musterdefinitionsvorrichtung (7, 7') eine quer zur Aperturenarray-Anordnung (af) positionierte Aperturenarrayeinrichtung (51) und eine quer zur Aperturenarray-Anordnung (af) positionierte Ablenkarrayeinrichtung (52) beinhaltet,
wobei die Aperturenarrayeinrichtung (51) besagte Vielzahl von Aperturen (50) in der Aperturenarray-Anordnung umfasst, welche Aperturen (50) dazu eingerichtet sind, die Form der in der Musterdefinitionsvorrichtung gebildeten Teilstrahlen zu definieren,
wobei die Ablenkarrayeinrichtung (52) aufweist:
- eine Vielzahl von Blanking-Öffnungen (520), die den Durchtritt von Teilstrahlen durch die Ablenkarrayeinrichtung gestatten, und
- eine Vielzahl von Ablenkvorrichtungen (521, 501), wobei jede der Ablenkvorrichtungen einer jeweiligen Blanking-Öffnung (520) zugeordnet ist und zumindest eine elektrostatische Elektrode (522, 523, 502) aufweist, wobei die Ablenkvorrichtungen selektiv aktivierbar sind und dazu eingerichtet sind, in aktiviertem Zustand die Teilstrahlen, die die jeweiligen Blanking-Öffnungen durchqueren, derart zu beeinflussen, dass diese Teilstrahlen um einen Betrag abgelenkt werden, der dazu ausreicht, diese Teilstrahlen von ihren nominellen Bahnen weg zu lenken, mit Ausnahme einer oder mehreren defekten Ablenkvorrichtungen (501), die dauerhaft zum Ablenken der Teilstrahlen, die Blanking-Öffnungen, denen die defekten Ablenkvorrichtungen zugeordnet sind, durchqueren, unfähig sind und somit diese Teilstrahlen (b') als "unabgelenkte Teilstrahlen" belassen,
wobei die Musterdefinitionsvorrichtung (7, 7') zudem eine Filtereinrichtung (53) in Form einer plattenförmigen Vorrichtung aufweist, welche aufweist:
- eine Vielzahl von Durchgangsöffnungen (70) in Form eines Array von Öffnungen, die der Vielzahl von Blanking-Öffnungen (520) der Ablenkarrayeinrichtung (52) entsprechen und die den Durchtritt von Teilstrahlen durch die Filtereinrichtung für zumindest die Teilstrahlen, die durch Blanking-Öffnungen (520) der Ablenkarrayeinrichtung (52) hindurchtreten, bei denen die jeweiligen Ablenkvorrichtungen (521) nicht defekt sind, gestatten, und
- eine Vielzahl von Sperrvorrichtungen (71, 74), wobei jede Sperrvorrichtung einer jeweiligen Öffnung (70) zugeordnet ist und zumindest eine elektrostatische Elektrode (72, 73, 742, 743) aufweist, wobei jede Sperrvorrichtung für das Einnehmen zweier dauerhafter Zustände in Bezug auf zumindest einen der unabgelenkten Teilstrahlen (b') programmierbar ist, nämlich einen offenen Zustand (71), der den/die jeweiligen unabgelenkten Teilstrahl(en) nicht beeinflusst, und einen Sperrzustand (74), wobei die Sperrvorrichtungen selektiv aktivierbar sind, um den Sperrzustand (74) dadurch zu verwirklichen, dass die Teilstrahlen, die die jeweiligen Öffnungen durchqueren, aus ihrer nomineller Bahn weg zu lenken, wodurch die jeweiligen Teilstrahlen eine Mindestdauer lang davon abgehalten werden, die Musterdefinitionsvorrichtung (7, 7') entlang ihrer nominellen Bahn stromabwärts der Musterdefinitionsvorrichtung zu durchqueren,
**dadurch gekennzeichnet, dass** die Bahnen all jener Teilstrahlen, die die durch Blanking-Öffnungen (520) der Ablenkarrayeinrichtung (52) laufen, bei denen die jeweiligen Ablenkvorrichtungen (521) nicht defekt sind, nicht durch die Filtereinrichtung (53) beeinflusst werden .

2. Musterdefinitionsvorrichtung nach Anspruch 1, bei welcher die Öffnungen in der Aperturenarray-Anordnung (af) in einem Array mit mehreren Zeilen von Öffnungen angeordnet sind, wobei jede Zeile eine Anzahl von Öffnungen umfasst.

3. Musterdefinitionsvorrichtung nach Anspruch 1, bei welcher die Sperrvorrichtung (71) dazu eingerichtet ist, in den Sperrzustand (74) für eine Mindestdauer, die größer ist als das Produkt der typischen Aktivierungsdauer der Ablenkvorrichtungen (521) in der Ablenkarrayeinrichtung (52) mal die Anzahl der Öffnungen in einer Zeile von Öffnungen in der Ablenkarrayeinrichtung, schaltbar zu sein.

4. Musterdefinitionsvorrichtung nach einem der vorhergehenden Ansprüche, bei welcher die Ablenkarrayeinrichtung (52) in Form einer plattenförmigen Vorrichtung mit einer entsprechenden Anordnung von Öffnungen (70) ausgebildet ist, und die Filtereinrichtung (53) quer zur Aperturenarray-Anordnung im Wesentlichen parallel zu der Ablenkarrayeinrichtung (52) positioniert ist.

5. Musterdefinitionsvorrichtung nach einem der vorhergehenden Ansprüche, bei welcher die Aperturenarrayeinrichtung (51) und die Ablenkarrayeinrichtung (52) als unterschiedliche Komponenten in gestapelter Konfiguration ausgebildet sind.

6. Musterdefinitionsvorrichtung nach einem der vorhergehenden Ansprüche, wobei die Filtereinrichtung (53) die letzte Komponente der Musterdefinitionsvorrichtung in Blickrichtung entlang der Richtung des Strahles darstellt und eine stromabwärts gewandte Oberfläche mit glatter, vorzugsweise planarer, Formgebung abgesehen von den besagten Öffnungen beinhaltet.

7. Musterdefinitionsvorrichtung nach einem der vorhergehenden Ansprüche, bei welcher die Anzahl der defekten Ablenkvorrichtungen um zumindest eine Größenordnung kleiner ist als die Gesamtanzahl von Ablenkvorrichtungen in der Ablenkarrayeinrichtung.

8. Teilchenstrahl-Bearbeitungs- oder -Inspektionsgerät (100) mit einer Multistrahl-Musterdefinitionsvorrichtung (7, 7') gemäß einem der vorhergehenden Ansprüche.

## Revendications

1. Dispositif de définition de motif (7, 7') destiné à être utilisé dans un appareil d'inspection ou de traitement à faisceaux multiples de particules chargées (100), ledit dispositif comprenant un champ de réseau d'ouvertures (af) configuré pour être irradié par un faisceau (lp) de particules chargées électriquement et permettre le passage du faisceau à travers une pluralité d'ouvertures formant ainsi un nombre correspondant de petits faisceaux, chacun des petits faisceaux traversant le champ de réseau d'ouvertures (af) le long d'un trajet de petit faisceau respectif (p0) à travers le dispositif de définition de motif et s'étendant en aval du dispositif de définition de motif sur un trajet nominal respectif pour chaque petit faisceau,
le dispositif de définition de motif (7, 7') comprenant un dispositif de réseau d'ouvertures (51) positionné en travers du champ de réseau d'ouvertures (af) et un dispositif de réseau de déviation (52) positionné en travers du champ de réseau d'ouvertures (af),
ledit dispositif de réseau d'ouvertures (51) comprenant ladite pluralité d'ouvertures (50) dans le champ de réseau d'ouvertures, lesquelles ouvertures (50) sont configurées pour définir la forme des petits faisceaux formés dans le dispositif de définition de motif,
ledit dispositif de réseau de déviation (52) comprenant :
- une pluralité d'ouvertures d'extinction (520) permettant le passage de petits faisceaux à travers le dispositif de réseau de déviation, et
- une pluralité de dispositifs de déviation (521, 501), chacun desdits dispositifs de déviation étant associé à une ouverture d'extinction respective (520) et comprenant au moins une électrode électrostatique (522, 523, 502), les dispositifs de déviation étant activables de manière sélective et configurés pour influencer, lorsqu'activés, les petits faisceaux traversant lesdites ouvertures d'extinction respectives de façon à dévier lesdits petits faisceaux d'une grandeur suffisante pour détourner lesdits petits faisceaux de leurs trajets nominaux, à l'exception d'un ou plusieurs dispositifs de déviation défectueux (501) qui sont irrémédiablement incapables de dévier les petits faisceaux traversant des ouvertures d'extinction auxquelles les dispositifs de déviation défectueux sont associés, laissant ainsi ces petits faisceaux (b') en tant que « petits faisceaux non déviés »,
le dispositif de définition de motif (7, 7') comprenant en outre un dispositif de filtrage (53) réalisé sous la forme d'un dispositif en forme de plaque comprenant :
- une pluralité d'ouvertures de passage (70) réalisées sous la forme d'un réseau d'ouvertures qui correspondent à la pluralité d'ouvertures d'extinction (520) du dispositif de réseau de déviation (52) et qui permettent le passage de petits faisceaux à travers le dispositif de filtrage pour au moins les petits faisceaux passant à travers des ouvertures d'extinction (520) du dispositif de réseau de déviation (52) où les dispositifs de déviation respectifs (521) ne sont pas défectueux, et
- une pluralité de dispositifs de blocage (71, 74), chaque dispositif de blocage étant associé à une ouverture respective (70) et comprenant au moins une électrode électrostatique (72, 73, 742, 743), chaque dispositif de blocage étant programmable pour prendre deux états permanents par rapport à au moins un des petits faisceaux non déviés (b'), à savoir, un état ouvert (71) n'affectant pas le ou les petits faisceaux non déviés respectifs et un état de blocage (74), les dispositifs de blocage étant activables de manière sélective pour réaliser l'état de blocage (74) par détournement des petits faisceaux traversant lesdites ouvertures respectives de leur trajet nominal, empêchant ainsi les petits faisceaux respectifs de traverser le dispositif de définition de motif (7, 7') le long de leurs trajets nominaux respectifs en aval du dispositif de définition de motif pendant une durée minimale,
**caractérisé par le fait que** les trajets de tous ces petits faisceaux, qui passent à travers des ouvertures d'extinction (520) du dispositif de réseau de déviation (52) où les dispositifs de déviation respectifs (521) ne sont pas défectueux, ne sont pas affectés par ledit dispositif de filtrage (53).

2. Dispositif de définition de motif selon la revendication 1, dans lequel les ouvertures dans le champ de réseau d'ouvertures (af) sont disposées en un réseau comprenant de multiples rangées d'ouvertures, chaque rangée comprenant un nombre d'ouvertures.

3. Dispositif de définition de motif selon la revendication 1, dans lequel le dispositif de blocage (71) est configuré pour être apte à commuter vers l'état de blocage (74) pendant une durée minimale supérieure au produit de la durée typique d'activation des dispositifs de déviation (521) dans le dispositif de réseau de déviation (52) fois le nombre d'ouvertures dans une rangée d'ouvertures dans le dispositif de réseau de déviation.

4. Dispositif de définition de motif selon l'une quelconque des revendications précédentes, dans lequel le dispositif de réseau de déviation (52) est réalisé sous la forme d'un dispositif en forme de plaque comprenant un réseau respectif d'ouvertures (70), et le dispositif de filtrage (53) est positionné en travers du champ de réseau d'ouvertures sensiblement parallèlement au dispositif de réseau de déviation (52).

5. Dispositif de définition de motif selon l'une quelconque des revendications précédentes, dans lequel le dispositif de réseau d'ouvertures (51) et le dispositif de réseau de déviation (52) sont réalisés sous la forme de composants différents dans une configuration empilée.

6. Dispositif de définition de motif selon l'une quelconque des revendications précédentes, dans lequel le dispositif de filtrage (53) représente le dernier composant du dispositif de définition de motif vu selon la direction du faisceau et comprend une surface aval de forme lisse, de préférence plate, à l'exception desdites ouvertures.

7. Dispositif de définition de motif selon l'une quelconque des revendications précédentes, dans lequel le nombre de dispositifs de déviation défectueux est au moins un ordre de grandeur inférieur au nombre total de dispositifs de déviation dans le dispositif de réseau de déviation.

8. Appareil d'inspection ou de traitement à faisceaux de particules (100) comprenant un dispositif de définition de motif à faisceaux multiples (7, 7') selon l'une quelconque des revendications précédentes.
